# EUROPEAN PATENT APPLICATION

(11) **EP 3 214 911 A1**
(43) Date of publication of application: **06.09.2017**
(21) Application number: 16305250.9
(22) Date of filing: 04.03.2016
(51) Int. Cl.: H05K 7/20, G06F 1/20

(54) **APPARATUS COMPRISING A HOUSING WITH AN IMPROVED COOLING**

(71) Applicant: Thomson Licensing, 92130 Issy-les-Moulineaux (FR)
(72) Inventor: Van Vlerken, Stephan, 2260 Westerlo (BE)
(74) Representative: Huchet, Anne

(57) **Abstract**

The apparatus (11) comprises a housing with a first wall (12) and a second wall (13), and a printed circuit board (14) with an integrated circuit (15), on which a heat sink (16) is mounted, wherein the first wall (12) comprises a hole, and the heat sink (16) extends into the hole. The apparatus is in particular an access gateway.

## Description

### TECHNICAL FIELD

The disclosure relates to an apparatus comprising a housing, for example an access gateway.

### BACKGROUND

Access gateways are widely used to connect devices in a home to the Internet or any other wide area network (WAN). Access gateways use for example digital subscriber line (DSL) technology that enables a high data rate transmission over copper lines or via optical fiber. Access gateways including wireless technology have a key role in today's home and professional environments.

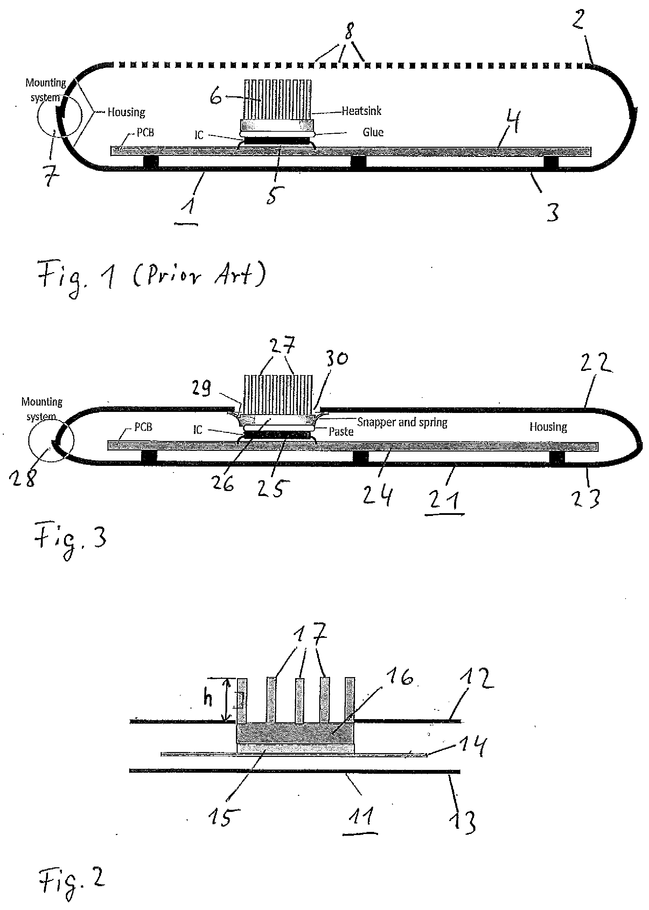

An access gateway 1 of this kind comprises for example a top wall 2, a bottom wall 3 and a printed circuit board (PCB) 4, on which integrated and non-integrated electronic circuits are arranged, as depicted in figure 1. The integrated circuits include in particular a microprocessor 5 for data processing, on which a heat sink 6 is mounted because of a high heat dissipation during the operation of the microprocessor 5. The top wall 2 and the bottom wall 3 are mounted together via a snap-in mechanism 7. The top wall 2 includes in this embodiment venting holes 8 to support the cooling of the microprocessor 5. The heat sink 6 is fixed on the microprocessor 5 by using a glue or a mechanical fixing. It is desirable to provide an apparatus of this kind having an improved heat dissipation.

### SUMMARY

An apparatus comprises a housing with a first wall and a second wall, and a printed circuit board with an integrated circuit, on which a heat sink is mounted, wherein the first wall comprises a hole, and the heat sink extends into the hole. The heat sink of the integrated circuit is therefore directly exposed to the outside air.

In a preferred embodiment, the heat sink comprises fins, and the fins protrude out of the first wall by a length. The heat of the heat sink is therefore directly transferred from the component to the outside of the housing, so that a free air flow is provided, not restricted by the housing.

In an aspect of the invention, the heat sink comprises elastic snappers or springs at its side walls, which extend the size of the ground part of the heatsink to be larger than the area of the hole of the first wall, so that the first wall pushes the heatsink onto the integrated circuit, when the housing is closed.

The heat sink is in particular a non-electrically conductive heat sink or a non-metallic heat sink.

The apparatus is for example an access gateway and the first wall is a top cover and the second wall is a bottom cover of the access gateway.

### BRIEF DESCRIPTION OF THE DRAWINGS

Preferred embodiments of the disclosure are explained in more detail below by way of example with reference to schematic drawings, which show:
- Fig. 1: an access gateway according to prior art,
- Fig. 2: an apparatus comprising an improved heat dissipation, and
- Fig. 3: an access gateway comprising an improved heat dissipation, and
- Figs. 4a, 4b: the access gateway of figure 3 in a cross section and in a top view.

### DETAILED DESCRIPTION OF PREFERRED EMBODIMENTS

The present description illustrates the principles of the present disclosure. It will thus be appreciated that those skilled in the art will be able to devise various arrangements that, although not explicitly described or shown herein, embody the principles of the disclosure and are included within its scope.

All examples and conditional language recited herein are intended for instructional purposes to aid the reader in understanding the principles of the disclosure and the concepts contributed by the inventors to furthering the art, and are to be construed as being without limitation to such specifically recited examples and conditions.

Moreover, all statements herein reciting principles, aspects, and embodiments of the disclosure, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

In figure 2, a part of an apparatus 11 is schematically illustrated in a cross section, the apparatus comprising a first wall 12, a second wall 13 and a printed circuit board (PCB) 14, on which an integrated circuit 15, in this embodiment a microprocessor 15, is mounted. On the integrated circuit 15, or any other heat dissipating component, a heatsink 16 is arranged for heat dissipation. The first wall 12 comprises a hole having about the size of the heatsink 16, and the heatsink 16 extends through the hole of the first wall 12, so that the fins 17 of the heatsink 16 are at least partly outside of the housing of the apparatus 11. In this embodiment, the fins 17 of the heatsink 16 extend by a height h over the first wall 12, so that an improved airflow is provided for the heatsink 16.

An access gateway 21 comprising an improved heat dissipation in accordance with the apparatus of figure 2 is illustrated in figure 3. The access gateway 21 comprises a top wall 22 and a bottom wall 23 and a PCB 24 with an integrated circuit 25. The housing includes a snap-in mechanism 28, via which the bottom wall 23 and the top wall 22 are fixed together to close the housing. The snap-in mechanism 28 corresponds in this embodiment with the snap-in mechanism 7 of figure 1.

The top wall 22 includes a hole 30 corresponding to the size of the heatsink 26 and the fins 27, and the heatsink 26 extends through the hole 30, to provide an improved venting for the heatsink 26. In this embodiment, the heatsink 26 comprises elastic snappers 29 at its side walls, which extend the size of the ground part of the heatsink 26 to be larger than the area of the hole 30 of the top wall 22, so that the top wall 22 pushes the heatsink 26 onto the integrated circuit 25, when the housing is closed, to provide a secure fixing of the heatsink 26 on the integrated circuit 25.

With an arrangement of this kind, less or no venting holes are required in any walls of the housing. In addition, the heat within the access gateway 21 is reduced with regard to the access gateway 1 as illustrated in figure 1, because the heat as generated by the integrated circuit 25 is transferred directly to the outside of the access gateway 21 by the heatsink 26. The heatsink 26 is in particular a plastic heatsink or a nonconducting heatsink, so that the access gateway 21 does not provide any danger for a user when in operation. The heatsink 26 can be made for example as a plug-in module being pushed by the top wall 22 onto the integrated circuit 25 and a heat-conductive paste can be provided between the heatsink 26 and the integrated circuit 25 to improve the heat dissipation between the integrated circuit 25 and the heatsink 26. In addition, the electrostatic protection of the access gateway 21 is improved, because the top wall 22 and the bottom wall 23 do not include any holes, through which an electrostatic discharging can occur. Further, the housing can be more compact, because the large heat sink is not provided within the housing.

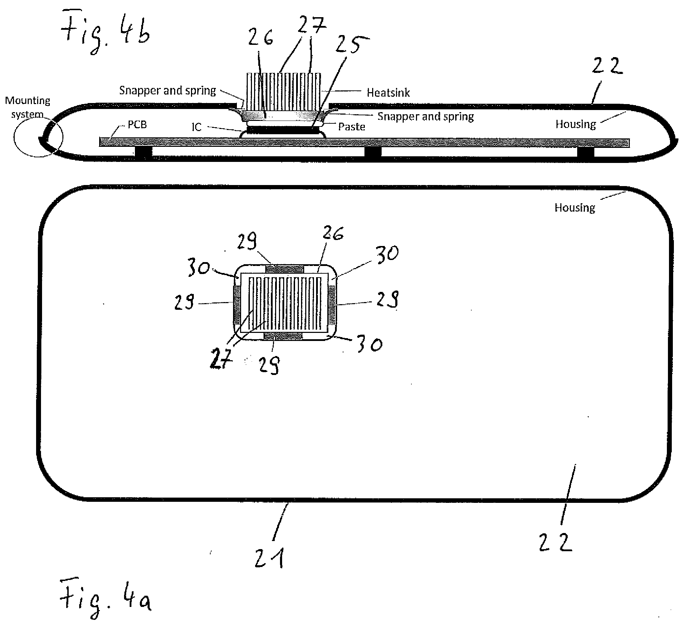

The access gateway as described with regard to figure 3 is illustrated in figure 4a in a top view and in figure 4b in a cross section corresponding with figure 3, showing the integrated circuit 25 with the heatsink 26. As can be seen in figure 4a, the hole 30 of the top wall 22 is larger than the area of the base of the heatsink 26 and the fins 27, so that the fins 27 can extend outside of the housing of the access gateway 21. In this arrangement, the hole 30 and the heatsink 26 have each about a rectangular shape, and the heatsink 26 comprises at each of its side walls an elastic snapper 29, which extends below the top wall 22, so that the heatsink 26 is firmly pushed onto the integrated circuit 25, when the top and bottom walls of the access gateway 21 are closed. The heatsink 26 is therefore firmly secured onto the integrated circuit of the access gateway 21.

Also other embodiments may be utilized by one skilled in the art without departing from the scope of the present disclosure. The disclosure is in particular applicable for an access gateway, but may be applied also for any other apparatuses comprising a housing with a first wall and a second wall, and a printed circuit board with an integrated circuit, on which a heat sink is mounted. The disclosure resides therefore in the claims herein after appended.

## Claims

1. An apparatus (11, 21) comprising
a housing with a first wall (12, 22) and a second wall (13, 23); and
a printed circuit board (14, 24) with an integrated circuit (15, 25), on which a heat sink (16, 26) is mounted; characterized that
the first wall (12, 22) comprises a hole (30), and
the heat sink (16, 26) extends into the hole (30).

2. The apparatus of claim 1, wherein the heat sink comprises fins (17, 27), and the fins protrude out of the first wall (12, 22) by a length (h).

3. The apparatus of claim 1 or 2, wherein the heat sink (16, 26) comprises an elastic snapper or a spring (29) at least on two sides of the heatsink, so that the first wall (12, 22) presses the heat sink onto the integrated circuit (15, 25).

4. The apparatus of claim 3, wherein the heat sink (16, 26) comprises elastic snappers (29) at its side walls, which extend the size of the ground part of the heatsink (26) to be larger than the area of the hole (30) of the first wall (22), so that the first wall pushes the heatsink onto the integrated circuit (25), when the housing is closed.

5. The apparatus of one of the preceding claims, wherein the first wall (12, 22) is a top cover and the second wall (13, 23) is a bottom cover of the apparatus.

6. The apparatus of one of the preceding claims, wherein the heat sink is a non-electrically conductive heat sink or a non-metallic heat sink.

7. The apparatus of one of the preceding claims, wherein the housing consists of a plastic material.

8. The apparatus of one of the preceding claims, wherein the apparatus (11, 21) is an access gateway and the integrated circuit (15, 25) is a microprocessor.

9. The apparatus of one of the preceding claims, wherein the housing does not include venting holes (8).
